# EUROPÄISCHE PATENTANMELDUNG

(11) **EP 2 838 198 A1**
(43) Veröffentlichungstag der Anmeldung: **18.02.2015**
(21) Anmeldenummer: 13180540.0
(22) Anmeldetag: 15.08.2013
(51) Int. Cl.: H03K 17/96, G06F 3/044

(54) **Schalteinrichtung**

(71) Anmelder: RAFI GmbH & Co. KG, 88276 Berg (DE)
(72) Erfinder: Hofmann, Steffen, 88364 Wolfegg / Alttann (DE); Bulach, Eric, 88074 Meckenbeuren (DE); Seybold, Lothar, 88276 Berg (DE)
(74) Vertreter: Engelhardt & Engelhardt

(57) **Zusammenfassung**

Bei einer kapazitiven Schalteinrichtung (1, 1', 1", 1"'), durch die eine manuelle Bewegung und/oder punktuelle Berührung in ein elektrisches Schaltsignal umgewandelt sind, bestehend
- aus einer von außen zugänglichen Schaltfläche (3), deren Oberfläche aus einer als Gehäuse (2) ausgestalteter Kunststoffschicht bzw. einer Lackschicht (22) besteht,
- aus einer Vielzahl von elektrischen Leitungen (4, 5), die ein Gitternetz (6) bilden und durch die mindestens ein erster Körper zur Erzeugung der elektrischen Kapazität (20) geschaffen ist, wobei ein zweiter elektrisch leitende Körper (7) von dem ersten Körper (6) isoliert ist und vorzugsweise von einem menschlichen Finger (7) oder Handfläche gebildet ist,
soll die Schaltfläche (3) der Schalteinrichtung (1) Orientierungshilfen zu deren Bedienung aufweisen.

Dies ist dadurch erreicht, dass die Schaltfläche (3) mindestens bereichsweise eine dreidimensional ausgestaltete Außenkontur aufweist, dass die elektrischen Leitungen (4, 5) über die gesamte Erstreckung der Schaltfläche (3) angeordnet sind und dass die elektrischen Leitungen (4, 5) bzw. deren Gitternetz (6) an die dreidimensionale Außenkontur der Schaltfläche (3) angepasst sind.

## Beschreibung

Die Erfindung bezieht sich auf eine Schalteinrichtung, durch die manuelle Bewegungen in ein elektrisches Schaltsignal umgewandelt sind, nach dem Oberbegriff des Patentanspruches 1.

Es ist bekannt, kapazitive Schaltflächen für den Betrieb eines elektrischen Gerätes, beispielsweise eines Computers, eines Handys oder einer Werkzeugmaschine zu verwenden, die durch eine Glasscheibe oder eine durchsichtige Kunststoffplatte nach außen isoliert sind. Die im Inneren des Gehäuses angeordneten elektrischen Leiter erzeugen ein oder mehrere elektrische Kapazitäten. Diese elektrischen Leiter sind als erster Körper anzusehen. Sobald ein zweiter Körper, der elektrisch isoliert von dem ersten Körper ist, in die elektrische Kapazität eindringt, verändert sich diese. Eine solche Veränderung der Kapazität kann durch eine elektrische Auswerteeinheit, beispielsweise einen Mikrokontroller oder Mikroprozessor, festgestellt und ausgewertet werden. Da die elektrischen Leiter in X- und Y-Richtung, also senkrecht zueinander verlaufen, ist feststellbar, in welchem Bereich der Schaltfläche die Veränderung der Kapazität eingetreten ist und ob eine punktuelle Betätigung oder eine lineare Bewegung vorliegt, also Gestiken zu erkennen sind, so dass durch die elektrische Auswerteeinrichtung das entsprechende elektrische Schaltsignal generiert werden kann.

Die eben ausgestalteten Schaltflächen weisen den Nachteil auf, dass oftmals eine unbeobachtete Bedienung des elektrischen Gerätes nicht möglich ist, da der Benutzer keinerlei Bezugspunkte hat, in welchem Bereich der Schaltfläche er sich gerade befindet. Daher ist eine visuelle Kontaktaufnahme zwischen dem Benutzer und dem jeweiligen unterhalb der Schaltfläche angeordneten Schaltsymbol zwingend erforderlich, um eine ordnungsgemäße Bedienung des elektrischen Gerätes zu erreichen.

Es ist daher Aufgabe der Erfindung, eine Schalteinrichtung der eingangs genannten Gattung bereit zu stellen, deren Schaltfläche Orientierungshilfen aufweist, durch die eine Bedienung der Schalteinrichtung ohne visuelle Kontrolle ermöglicht wird.

Diese Aufgabe ist erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass die Schaltfläche mindestens bereichsweise eine dreidimensionale Außenkontur aufweist, dadurch, dass die elektrischen Leitungen über die gesamte Schaltfläche angeordnet sind und dadurch, dass die elektrischen Leitungen bzw. deren Gitternetz an die dreidimensionale Außenkontur der Schaltfläche angepasst ist, kann der Benutzer einer solchen Schalteinrichtung seine visuelle Aufmerksamkeit auf seine Umgebung richten und mit seinem Tastsinn die Schalteinrichtung bedienen, da die dreidimensionale Außenkontur der Schaltfläche eine Orientierungshilfe zur Verfügung stellt. Solche Schalteinrichtungen können insbesondere im Automobilbereich, beispielsweise für Landkraftmaschinen, Baumaschinen oder dergleichen eingesetzt werden, denn dann kann sich der Benutzer einer solchen Maschine uneingeschränkt auf seine Umgebung konzentrieren, ohne dass die Bedienung der Schalteinrichtung visuell zu kontrollieren ist.

Es ist besonders vorteilhaft, dass sich die elektrischen Leitungen in X- und Y-Richtung erstrecken und ein gemeinsames Gitternetz bilden, das sich über die gesamte Schaltfläche erstreckt, unabhängig davon, ob in die Schaltfläche Vertiefungen oder Erhebungen eingearbeitet bzw. angeformt sind, denn dadurch ist eine gemeinsame Auswertung über die gesamte Schaltfläche erreicht. Durch diese konstruktive Maßnahme werden erhebliche Kosten eingespart, denn für eine derart ausgestaltete Schaltfläche wird lediglich eine elektrische Auswerteeinrichtung benötigt, durch die die jeweiligen punktuellen Betätigungen und/oder linearen Bewegungen gleichzeitig erfasst und in elektrische Schaltsignale umgewandelt werden können.

Zudem ist die Bedienung einer solchen Schalteinrichtung auf einfache und unkomplizierte Weise möglich, denn die Schaltreihenfolge wird dann von der elektrischen Auswerteeinrichtung errechnet und in die entsprechenden Schaltsignale umgewandelt.

In der Zeichnung sind vier erfindungsgemäße Schalteinrichtungen mit unterschiedlich ausgestalteten dreidimensionalen Schaltflächen dargestellt, die nachfolgend näher erläutert sind. Im Einzelnen zeigt:
- Figur 1a: eine erste Schalteinrichtung mit einem Gehäuse in dessen Zentrum ein halbkugelförmige Schaltfläche vorgesehen ist, in perspektivischer Ansicht,
- Figur 1b: die Schalteinrichtung gemäß Figur 1 a mit einer Vielzahl von in X-und Y-Richtung verlaufenden elektrischen Leitungen zur Erzeugung einer nach außen abgestrahlten Kapazität,
- Figur 2: die Schalteinrichtung gemäß Figur 1a, in deren Gehäuse eine Leiterplatte, eine elektrische Auswerteeinrichtung und ein FPC angeordnet ist, an denen die elektrischen Leitungen angeschlossen sind,
- Figur 3a: die Schalteinrichtung gemäß Figur 1a in Explosionsdarstellung mit dem konstruktiven Aufbau der Schaltfläche als Bestandteil des Gehäuses und der Anordnung der elektrischen Leitungen innerhalb der Schaltfläche,
- Figur 3b: die Schalteinrichtung gemäß Figur 1a in Explosionsdarstellung mit dem konstruktiven Aufbau der Schaltfläche, die mittels einer Lackschicht nach außen isoliert ist und der Anordnung der elektrischen Leitungen innerhalb der Schaltfläche,
- Figur 4: eine zweite Schalteinrichtung mit einer dreidimensional ausgestalteten Schaltfläche, in die sowohl Vertiefungen als auch Erhebungen oder bogenförmige Rillen angearbeitet sind, in perspektivischer Ansicht,
- Figur 5: die Schalteinrichtung gemäß Figur 4 entlang der Schnittlinie V-V,
- Figur 6: die Schalteinrichtung gemäß Figur 4 im Schnitt und mit einer nach außen abgestrahlten Kapazität,
- Figur 7: eine dritte Schalteinrichtung mit einem Gehäuse und einer darin relativ zu dem Gehäuse beweglichen Schaltfläche, die mit im Gehäuseinneren angeordneten Drucksensoren und Drehmesssensoren zusammenwirkt, im Schnitt und
- Figur 8: eine vierte Schalteinrichtung mit einem Gehäuse und einer in dem Gehäuse gelagerten Schaltfläche und ein im Inneren des Gehäuses angeordneter Lautsprecher, durch den Schwingungen an das Gehäuse übertragen sind.

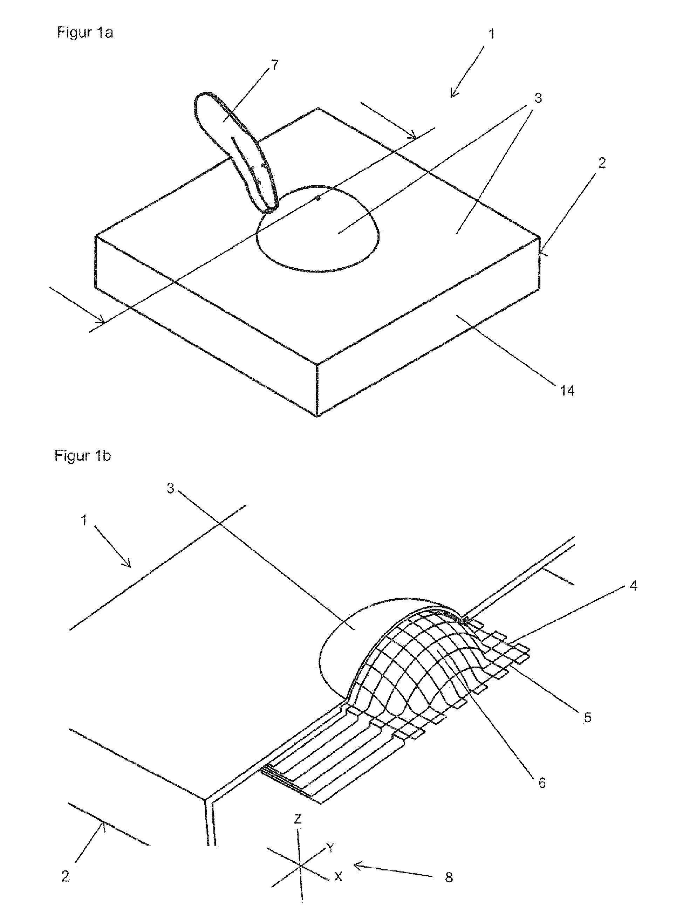

Die in den Figuren 1a und 1 b abgebildete Schalteinrichtung 1 besteht aus einer halbkugelförmig ausgestalteten Schaltfläche 3 die Bestandteil eines Gehäuses 2 ist. Der Übergangsbereich zwischen der Schaltfläche 3 und dem planen Gehäuse 2 ist einteilig, so dass dieser luft- und wasserdicht verschlossen ist. Zudem ist die Schaltfläche 3 und das Gehäuse 2 aus einem gemeinsamen Werkstoff hergestellt. Die Schalteinrichtung 1 dient dazu, ein oder mehrere elektrische Geräte, Werkzeugmaschinen, Kraftfahrzeuge oder dergleichen zu bedienen und durch die dreidimensionale Außenkontur der Schaltfläche 3 kann der Benutzer ohne visuelle Kontrolle erkennen, an welcher Position ein Finger oder ein Teilbereich der Handfläche sich befindet und dadurch die entsprechenden Schaltsignale manuell erzeugen, ohne dass visuelle Kontrollen notwendig sind.

Um eine entsprechende elektrische Kapazität zu erzeugen, sind in der Schaltfläche 3 eine Vielzahl von elektrischen Leitungen 4, 5 angeordnet, die sich im Übrigen über die gesamte Oberfläche des Gehäuses 2 erstrecken. Dabei sind die elektrischen Leitungen, die in X-Richtung verlaufen, mit der Bezugsziffer 4 gekennzeichnet und die elektrischen Leitungen, die in Y-Richtung angeordnet sind, mit der Bezugsziffer 5 versehen. Somit bilden die elektrischen Leitungen 4 und 5, die orthogonal zueinander stehen, ein gemeinsames Gitternetz 6.

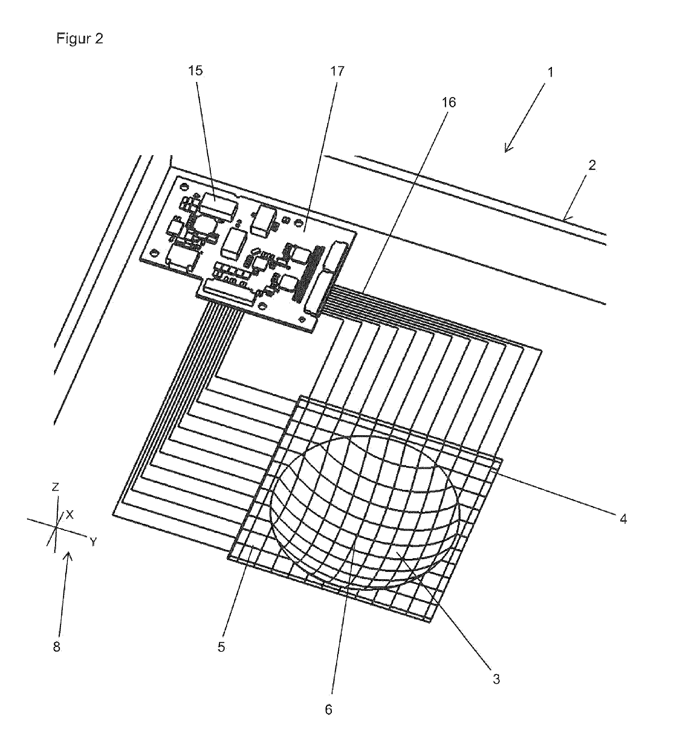

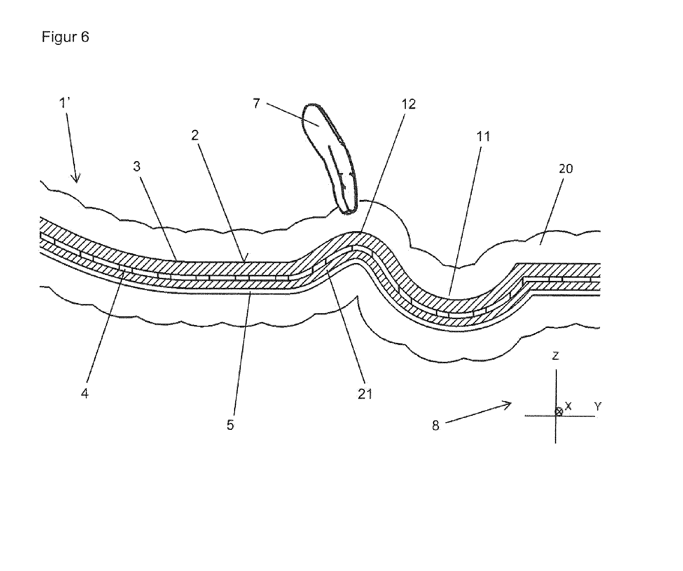

Die elektrischen Leitungen 4 und 5 sind bestromt, so dass diese die elektrische Kapazität 20 bilden, die beispielhaft in der Figur 6 dargestellt ist und demnach einen ersten Körper darstellen. Durch den menschlichen Finger 7 bzw. die menschliche Handfläche, die von den elektrischen Leitungen 4 und 5 elektrisch isoliert ist, entsteht ein zweiter Körper, der beim Eindringen in die elektrische Kapazität 20 eine entsprechende Veränderung der Kapazität 20 bewirkt, die von einer elektrischen Auswerteeinrichtung 15, wie dies in Figur 2 zu entnehmen ist, festgestellt wird und in ein elektrisches Schaltsignal umgewandelt ist. Die einzelnen elektrischen Leitungen 4 und 5 sind über ein FPC 16 (flexible printed circuit) mit einer Leiterplatte 17 bzw. mit der elektrischen Auswerteinrichtung 15 verbunden, so dass die auf der Oberfläche der Schaltfläche 3 und/oder des Gehäuses 2 erzeugte Veränderung der elektrischen Kapazität 20 in einem X-, Y-Koordinatensystem 8 umgerechnet werden kann, so dass durch die Auswerteeinrichtung 15 feststellbar ist, an welcher Position entweder eine punktuelle und/oder eine lineare Berührung erfolgte.

Aus Figur 2 ist zudem ersichtlich, dass die dreidimensionale Schaltfläche 3 benachbart zu einer plan ausgestalteten Schaltfläche 3 angeordnet ist und dass sich die elektrischen Leitungen 4 und 5 in X- und Y-Richtung über die samte Oberfläche erstrecken. Folglich kann die Schalfläche 3 teilweise gewölbt, also halbkugelförmig ausgestaltet und benachbart dazu plan ausgestaltet sein.

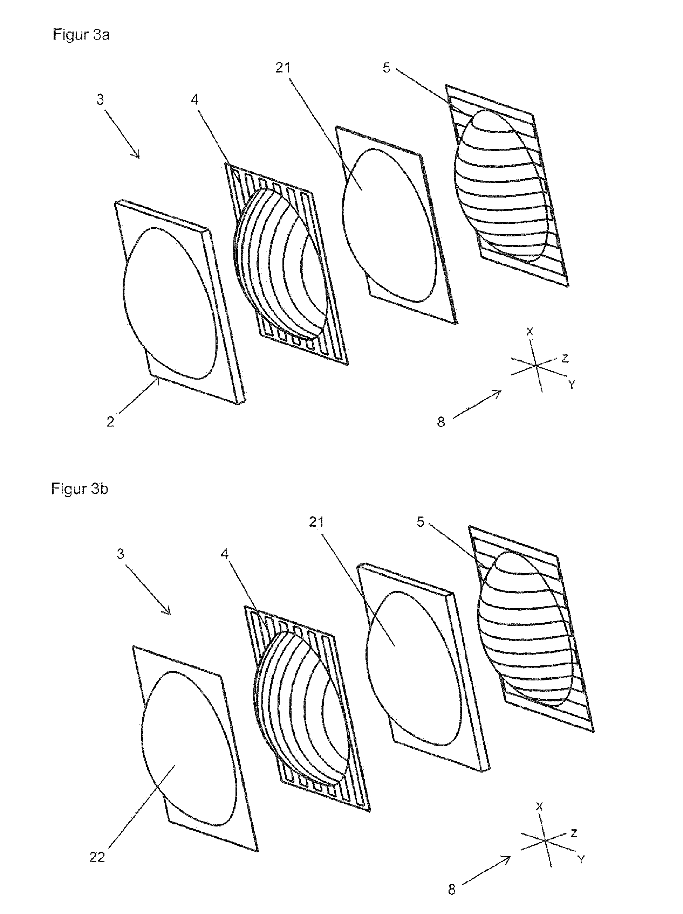

Aus Figur 3a ist der konstruktive Aufbau der dreidimensional ausgestalteten bzw. gewölbten Schaltfläche 3 abgebildet. Die Schaltfläche 3 besteht dabei aus einem Grundkörper 21, der bereits die vorgegebene gewölbte bzw. halbkugelförmige Außenkontur aufweist. Auf der Außenseite des Grundkörpers 21 sind dabei die in X-Richtung verlaufenden elektrischen Leitungen 4, beispielsweise mittels Laserstrahlen oder als dünnwandige Folie, aufgetragen; auf der Innenseite des Grundkörpers 21 sind die in Y-Richtung verlaufenden elektrischen Leitungen 5 aufgebracht. Um die elektrischen Leitungen 4 nach außen zu isolieren, ist das Gehäuse 2 über den Grundkörper 21 und die Leitungen 4, 5 geführt. Folglich sind die elektrischen Leitungen 4 abgedeckt. Die elektrischen Leitungen 4 sind zudem von den elektrischen Leitungen 5 beabstandet und isoliert. Der Abstand der elektrischen Leitungen 4 und 5 zueinander bzw. zu den jeweils senkrecht verlaufenden Leitungen 4 bzw. 5 ist vorgegeben und konstant.

In Figur 3b sind die elektrischen Leitungen 4 mittels einer Lackschicht 22 nach außen isoliert abgedeckt.

Der Grundkörper 21 kann in beiden Ausführungsvarianten der Figuren 3a und 3b aus einem biegeelastischen oder biegesteifen Werkstoff hergestellt sein.

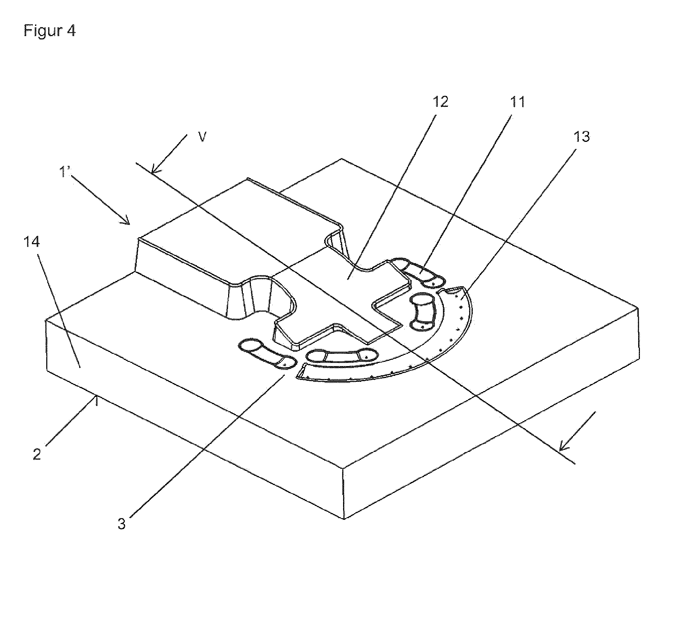

Aus Figur 4 ist eine andersartige Ausgestaltung einer Schalteinrichtung 1' zu entnehmen, die nunmehr aus Vertiefungen 11 und Erhöhungen 12 besteht. Die Vertiefungen 11 sind dabei an den Außenumfang eines menschlichen Fingers angepasst und können sowohl punktuell bzw. kreisbogenförmig ausgestaltet sein, als auch als Rille zur Aufnahme von Bewegungen. Dabei können die Rillen 13 sowohl bogenförmig als auch linear verlaufen.

Die Erhöhungen 12 sind noppenartig ausgestaltet, so dass auch diese von dem menschlichen Finger 7 ohne weiteres erkannt werden können. Folglich kann die Handfläche eines Benutzers auf die Schalteinrichtung 1' aufgelegt werden und durch die dreidimensionale Struktur der Schaltfläche 3 ist ohne visuelle Kontrolle von dem Benutzer feststellbar, an welcher Position der Schaltfläche 3 sein entsprechender Finger 7 zur Erzeugung eines Schaltsignales momentan bezogen auf die gewünschte Schaltsymbolik angeordnet ist.

Die Vertiefungen 11 sowie die Erhöhungen 12 sind derart angeordnet, dass diese jeweils einem Finger 7 einer menschlichen Hand zugeordnet sind.

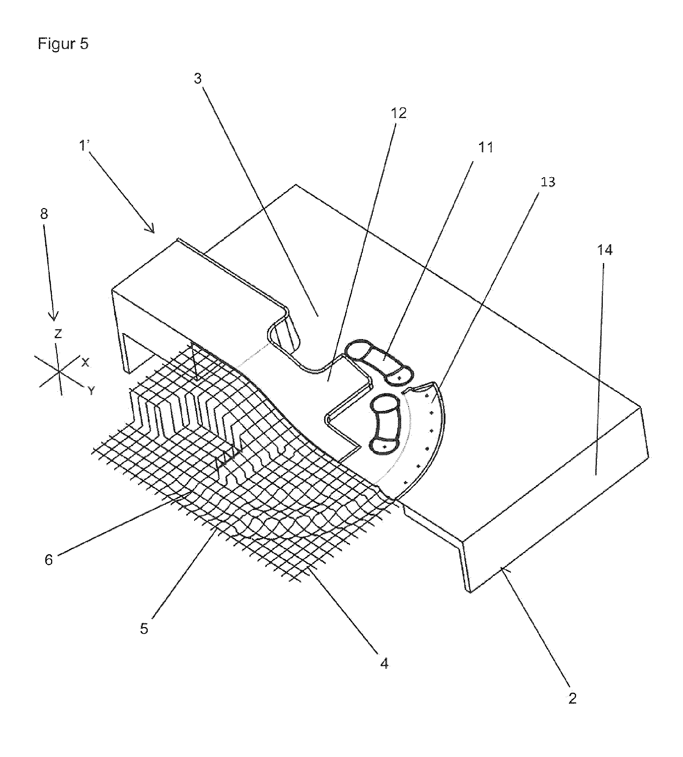

In Figur 5 ist dargestellt, dass die Schaltfläche 3 der Schalteinrichtung 1' ausschließlich ein gemeinsames Gitternetz 6 der elektrischen Leitungen 4 und 5 aufweist und dass die elektrischen Leitungen 4 und 5 an die Konturen der Schaltfläche 3 angepasst sind. Die elektrischen Leitungen 4 und 5 verlaufen demnach in einem konstanten Abstand zu der Oberfläche der Schaltfläche 3 und sind in entsprechender Weise, wie in Figur 3 erläutert, voneinander beabstandet. Es entstehen somit keine Kreuzungspunkte der elektrischen Leitungen 4 und 5 durch die nämlich ein Kurzschluss erzeugt wäre.

Die in den Figuren 4, 5 und 6 abgebildete Schalteinrichtung 1' weist zu der ersten Schaltfläche 3 orthogonal dazu verlaufende Schaltflächen 14 auf, die somit den Randbereich des Gehäuses 2 bilden. Solche Schaltflächen 14 können entlang jeder Kante der Schaltfläche 3 verlaufen, so dass diese jeweils zueinander senkrecht stehen. Das von den elektrischen Leitungen 4 und 5 gebildete Gitternetz 6 erstreckt sich dabei durch jede der vorgesehenen Schaltflächen 3 bzw. 14.

In Figur 6 soll schematisch dargestellt werden, welche Querschnittskonturen die Schaltflächen 3 über ihre jeweilige Erstreckung aufweisen und dass die Kapazität 20 nicht nur durch eine punktuelle oder lineare Berührung des menschlichen Fingers 7, sondern bereits bei dessen Annäherung an die Schaltfläche 3 verändert werden kann.

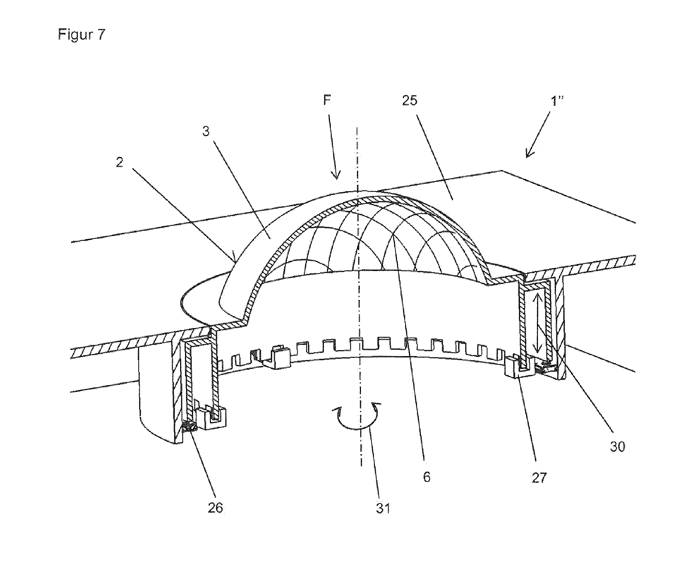

Aus Figur 7 ist eine dritte Ausführungsvariante einer Schalteinrichtung 1" zu entnehmen, deren Schaltfläche 3 und das Gehäuse 2 relativ beweglich in einer Blende 25 angeordnet sind. Die Schaltfläche 3 und das Gehäuse 2 bestehen weiterhin aus einem gemeinsamen Werkstoff. Die Blende 25 stützt demnach das Gehäuse 2 und die Schaltfläche 3 ab.

Im Inneren des Gehäuses 2 sind Taster 26 montiert, die mit der Unterseite der Schaltfläche 3 zusammenwirken. Sobald daher die Schaltfläche 3 und das Gehäuse 2 in Richtung der Taster 26 durch eine Betätigungskraft F gedrückt sind, lösen die Taster 26 ein entsprechendes elektrisches Schaltsignal aus.

Darüber hinaus kann die kugelartige Schaltfläche 3 und das Gehäuse 2 um ihre Symmetrieachsen, die senkrecht zu der Blende 25 verlaufen, gedreht werden. Im Inneren des Gehäuses 2 weist die Schaltfläche 3 eine Verzahnung auf, die mit einem Lichtsensor 27, beispielsweise einem Laser, zusammenwirkt. Sobald daher die Schaltfläche 3 gedreht ist, erkennt der fest mit der Blende 25 verbundene Sensor 27, in welcher Drehstellung die Schaltfläche 3 angeordnet ist, so dass ein entsprechendes elektrisches Schaltsignal generierbar ist.

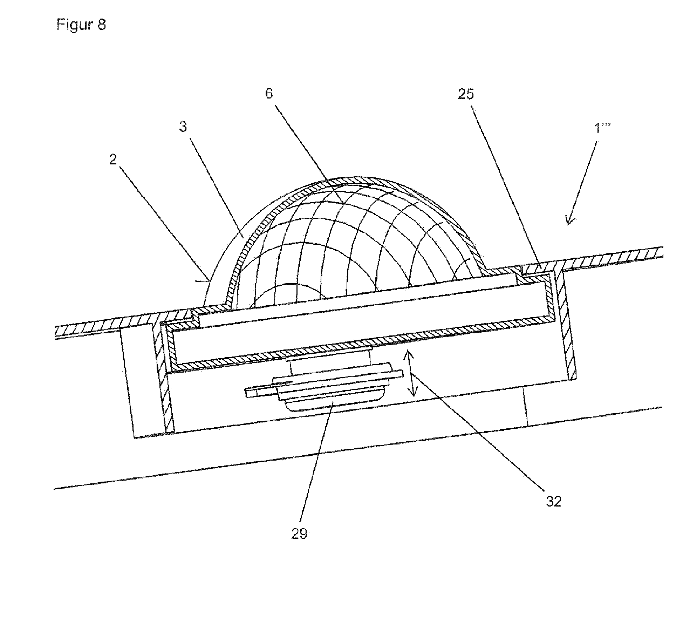

In Figur 8 ist eine vierte Ausführungsvariante einer Schalteinrichtung 1'" abgebildet, die einen Lautsprecher 29 im Inneren des Gehäuses 2 aufweist. Der Lautsprecher 29 ist dabei mit der Schaltfläche 3 gekoppelt und sobald ein entsprechendes Schaltsignal generiert ist, ist der Lautsprecher 29 aktiviert und sendet Schwingungen oder Schaltsignale an die Schaltfläche 3. Die von dem Lautsprecher 29 ausgestrahlten Schallwellen erzeugen eine Vibration in der Schaltfläche 3, wodurch der Benutzer feststellen kann, ob seine entsprechende manuelle Bedienung das gewünschte Schaltsignal erzeugt hat.

Allen vier Schalteinrichtungen 1, 1', 1" und 1'" können mit verschiedenartigen Computer-Softwareprogrammen ausgestattet sein, so dass die einzelnen Felder der Schaltfläche 3 auf die unterschiedlichste Weise programmierbar sind.

## Patentansprüche

1. Kapazitive Schalteinrichtung (1, 1', 1 ", 1 "'), durch die eine manuelle Bewegung und/oder punktuelle Berührung in ein elektrisches Schaltsignal umgewandelt sind, bestehend
- aus einer von außen zugänglichen Schaltfläche (3), deren Oberfläche aus einer als Gehäuse (2) ausgestalteter Kunststoffschicht bzw. einer Lackschicht (22) besteht,
- aus einer Vielzahl von elektrischen Leitungen (4, 5), die ein Gitternetz (6) bilden und durch die mindestens ein erster Körper zur Erzeugung der elektrischen Kapazität (20) geschaffen ist, wobei ein zweiter elektrisch leitende Körper (7) von dem ersten Körper (6) isoliert ist und vorzugsweise von einem menschlichen Finger (7) oder Handfläche gebildet ist,
**dadurch gekennzeichnet,**
**dass** die Schaltfläche (3) mindestens bereichsweise eine dreidimensional ausgestaltete Außenkontur aufweist, dass die elektrischen Leitungen (4, 5) über die gesamte Erstreckung der Schaltfläche (3) angeordnet sind und dass die elektrischen Leitungen (4, 5) bzw. deren Gitternetz (6) an die dreidimensionale Außenkontur der Schaltfläche (3) angepasst sind.

2. Schalteinrichtung nach Anspruch 1,
**dadurch gekennzeichnet,**
**dass** der Abstand zwischen der Schaltfläche (3) und den elektrischen Leitungen (4, 5) konstant ist und dass die einzelnen elektrischen Leitungen (4, 5) in X-, Y- und Z-Richtung eines dreidimensionalen Koordinationssystems (8) beabstandet zueinander verlaufen.

3. Schalteinrichtung nach Anspruch 1 oder 2
**dadurch gekennzeichnet,**
**dass** die Außenkontur der Schaltfläche (3) halb- bzw. dreiviertelkugelförmig ausgestaltet ist.

4. Schalteinrichtung nach einem der vorgenannten Ansprüche,
**dadurch gekennzeichnet,**
**dass** in die Schaltfläche (3) mindestens eine Vertiefung (11) und/oder mindestens eine Erhöhung (12) eingearbeitet bzw. angeformt sind.

5. Schalteinrichtung nach Anspruch 4,
**dadurch gekennzeichnet,**
**dass** die Vertiefungen (11) und/oder Erhöhungen (12) an die Außenkontur eines menschlichen Fingers (7) angepasst sind und/oder dass die Vertiefungen (11 als Rillen (13) ausgestaltet sind.

6. Schalteinrichtung nach Anspruch 6,
**dadurch gekennzeichnet,**
**dass** die Rillen (13) kreisbogenförmig oder linear ausgestaltet sind.

7. Schalteinrichtung nach einem der vorgenannten Ansprüche,
**dadurch gekennzeichnet,**
**dass** die parallel zueinander verlaufenden elektrischen Leitungen die Veränderung der Kapazität (20) in X- bzw. die dazu orthogonal verlaufenden Leitungen (5) in Y-Richtung feststellen und dass durch eine mit den elektrischen Leitungen (4, 5) verbundene Auswerteeinheit (15) feststellbar ist, in welchem Bereich der Schaltfläche (3) eine punktuelle Berührung und/oder eine lineare Bewegung stattfindet, durch die die Kapazität (20) verändert ist.

8. Schalteinrichtung nach einem der vorgenannten Ansprüche,
**dadurch gekennzeichnet,**
**dass** an die Schaltfläche (3) mindestens eine weitere Schaltfläche (14) angeordnet ist, die zu der ersten und jeder weiteren Schaltfläche (3 bzw. 14) unter einem vorgegebenen Winkel, vorzugsweise unter 90°, geneigt ist, und dass jede der Schaltflächen (3 bzw. 14) von den elektrischen Leitungen (4, 5) durchzogen ist, die ein gemeinsames Gitternetz (6) bilden.

9. Schalteinrichtung nach einem der vorgenannten Ansprüche,
**dadurch gekennzeichnet,**
**dass** die Schaltfläche (3) aus einem biegesteifen oder biegeelastischen Grundkörper (21) gebildet ist und dass der Grundkörper (21) aus einem Werkstoff besteht, der galvanisch trennend wirkt.

10. Schalteinrichtung nach Anspruch 9
**dadurch gekennzeichnet,**
**dass** an der Oberseite des Grundkörpers (21) die in X-Richtung verlaufenden elektrischen Leitungen (4) und auf der Unterseite des Grundkörpers (21) die in Y-Richtung verlaufenden elektrischen Leitungen (5) angeordnet sind und dass der Grundkörper (21) eine elektrisch isolierende Trennschicht zwischen den Leitungen (4, 5) bildet.

11. Schalteinrichtung nach einem der vorgenannten Ansprüche,
**dadurch gekennzeichnet,**
**dass** der Grundkörper (21) der Schaltfläche (3) auf der Außenseite eine Lackschicht (22) aufweist, durch die die in X-Richtung verlaufenden elektrischen Leitungen (4) nach außen isoliert sind.

12. Schalteinrichtung nach einem der vorgenannten Ansprüche,
**dadurch gekennzeichnet,**
**dass** die elektrischen Leitungen (4, 5) durch einen FPC (16) an die elektrische Auswerteeinrichtung (15) angeschlossen sind.

13. Schalteinrichtung nach einem der vorgenannten Ansprüche,
**dadurch gekennzeichnet,**
**dass** der Schalteinrichtung (1 "') ein Lautsprecher (29) zugeordnet ist, durch den entsprechende Schallwellen generiert sind, die an die Schaltfläche (3) zur Erzeugung einer Vibration weitergeleitet sind.

14. Schalteinrichtung nach einem der vorgenannten Ansprüche,
**dadurch gekennzeichnet,**
**dass** die Schaltfläche (3) und das Gehäuse (2) in einer Blende (25) angeordnet sind und dass die Schaltfläche (3) und das Gehäuse (2) axial beweglich und/oder um die eigene Längsachse in der Blende (25) verdrehbar gelagert sind.
